# EUROPEAN PATENT APPLICATION

(11) **EP 2 192 447 A1**
(43) Date of publication of application: **02.06.2010**
(21) Application number: 08170061.9
(22) Date of filing: 27.11.2008
(51) Int. Cl.: G03F 7/20, G03F 7/36

(54) **Method of applying a pattern to a substrate**

(71) Applicant: Akzo Nobel Coatings International B.V., 6824 BM Arnhem (NL)
(72) Inventor: Klinkenberg, Huig, NL-2224 DD, Katwijk (zh) (NL); Wal van der Bouwe Pieter, NL-2203 EH, Noordwijk (NL); Berg van den, Keimpe Jan, NL-2171 PS, Sassenheim (NL)
(74) Representative: Schalkwijk, Pieter Cornelis

(57) **Abstract**

The invention relates to a method of applying a pattern to a coated substrate, said method comprising:
a) applying a liquid, radiation-curable coating composition to a substrate;
b) providing a mask having parts which are at least partly opaque and parts which are transparent with respect to the curing radiation;
c) irradiating said liquid coating through the mask, without contact between said mask and said coating, to cure the irradiated areas; and
d) curing the remaining, uncured areas of the coating;

wherein a layer thickness difference develops in said coating at the boundary between the areas cured in step c) and those cured in step d).

## Description

The invention relates to a method of applying a pattern to a coated substrate. Such a method is known from International patent application WO 2008/025508. This document is concerned with the use of radical scavengers to optimize diffusion properties. It describes a process for forming a polymeric relief structure. The method comprises the steps of: a) coating a substrate with a coating comprising one or more radiation-sensitive ingredients; b) locally treating the coated substrate with radiation to form a latent image; and c) polymerizing and/or cross-linking the resultant coated substrate. The locality of the irradiation of step b) of this citation is controlled using a mask which is in contact with the coating. The coating is solid when step b) is carried out and a latent image is formed. For development of the pattern a subsequent heating step is required.

A drawback of the known method is that the mask is in contact with the coating. This requires that the coating be dried or otherwise transformed to a solid form before locally treating the coated substrate with radiation. Furthermore, it is more difficult to carry out the method with substrates having three-dimensional surface contours, because the mask then has to be adapted to the contours of the substrate. Finally, the known method requires an additional heating step to develop the pattern. This adds to the complexity of the method and may be problematic in the case of heat-sensitive substrates.

There is a need for an improved method which avoids or alleviates one or more of the above-mentioned drawbacks.

We have now found a method of applying a pattern to a coated substrate which comprises the steps of:
a) applying a liquid, radiation-curable coating composition to a substrate;
b) providing a mask having parts which are at least partly opaque and parts which are transparent with respect to the curing radiation;
c) irradiating said liquid coating through the mask, without contact between said mask and said coating, to cure the irradiated areas; and
d) curing the remaining, uncured areas of the coating;
wherein a layer thickness difference develops in said coating at the boundary between the areas cured in step c) and those cured in step d).

The method of the invention is also suitable for curved substrates, because there is no need to align the mask to the contours of the substrate. As the pattern develops instantaneously from the liquid coating, without the formation of a latent pattern, there is no need for any after-treatment to develop the pattern, such as heating. This reduces the complexity of the method. Furthermore, the method is also suitable for heat-sensitive substrates.

### Brief description of the drawings:

Figure 1 shows an example of the alignment of mask and substrate.
Figure 2 shows a positive and a negative eighth-order Sierpinsky gasket as an example of a pattern to be applied to a coated substrate.
Figure 3 shows profilometric scans of a positive and a negative imprint of the Sierpinsky gasket as an example of a pattern applied to a coated substrate.

The liquid radiation-curable coating composition can be applied to the substrate by any method which is suitable for applying a liquid coating composition to a substrate. Examples of suitable methods are brushing, rolling, and spraying. The best results are frequently obtained when the coating composition is applied by spraying.

In the method of the invention any liquid radiation-curable coating composition can be used. In one embodiment, the radiation-curable coating composition is solvent-free. Alternatively, the viscosity of the radiation-curable coating composition may be lowered by the presence of a volatile organic solvent. It is also possible to use a water borne radiation-curable coating composition. Suitable radiation-curable coating compositions are generally known to the skilled person. Suitable monomers, oligomers, polymers, and photoinitiators for use in such coating compositions are known to the skilled person and described in, e.g., Kirk-Othmer, Encyclopedia of Chemical Technology, 3rd Edition, Volume 19, pp. 607 - 624, and references cited therein. It is also possible for the coating composition to be only partly cured by radiation and fully cured thermally. In this case, the thermal curing reaction may be the same as or different from the actinic radiation-induced curing reaction. Thus, the coating composition can also comprise groups which are not susceptible to actinic radiation-induced curing.

In one embodiment, the radiation-curable coating composition comprises binders comprising ethylenically unsaturated groups capable of radical polymerization, optionally in combination with reactive diluents comprising ethylenically unsaturated groups capable of radical polymerization. As free radical-polymerizable groups (meth)acrylate groups, allyl groups, and vinyl groups may be mentioned. Such coating compositions suitably also comprise a photoinitiator capable of generating free radicals upon irradiation. Suitable coating compositions of the above-mentioned type are for example known from Canadian patent application CA 2214281.

Another type of actinic radiation-curable coating composition cures by a cationic mechanism, for example by cationic ring opening polymerization or by cationic and/or acid-catalyzed cross-linking mechanisms. In that case the actinic radiation-curable coating composition comprises a photolatent acid. Suitable groups susceptible to cationic ring opening polymerization include cyclic ether groups, such as epoxide groups or oxetane groups. Examples of suitable groups susceptible to cationic and/or acid-catalyzed cross-linking mechanisms are vinyl ether groups or a combination of hydroxyl-containing polymers with melamine oligomers.

In a further embodiment, the coating composition comprises a photolatent base and a base-catalyzed polymerizable or curable material. It was found that a particularly good resolution of the pattern can be achieved with this embodiment. Examples of suitable photolatent bases are described in European patent application EP 0882072 A, in International patent application WO 94/28075, and in International patent application WO 01/92362.

The photolatent base is preferably selected from a 4-(ortho-nitrophenyl) dihydropyridine, optionally substituted with alkyl ether and/or alkyl ester groups, a quaternary organo-boron photoinitiator, and an α-amino acetophenone. The preferred α-amino acetophenone is a compound according to the following formula (I):

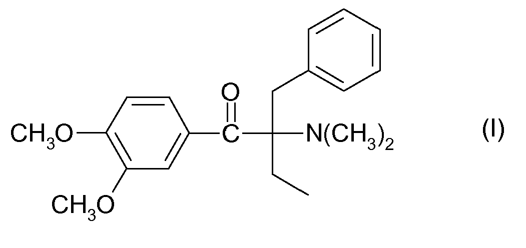

Mixtures comprising Michael donors, such as polyfunctional acetoacetates or malonates, and polyfunctional Michael acceptors, such as acryloyl-functional compounds, are suitable as base-catalyzed curable material. Such mixtures are described in more detail in the above-mentioned EP 0882072 A and WO 94/28075.

In a preferred embodiment the base-catalyzed curable material comprises at least one polyisocyanate and at least one compound comprising at least one thiol group. Such coating compositions are described in WO 01/92362.

In a still further embodiment, the radiation-curable coating composition comprises a hydroxy-functional binder, a polyisocyanate, and a photolatent catalyst for the addition reaction of hydroxy groups to isocyanate groups. Such coating compositions are described in WO 2007/147851.

As mentioned above, the method of the invention is very suitable for applying patterns to substrates having three-dimensional surface contours. Such substrates are not flat, but may for example be curved or bent at the surface. Since there is no contact between the mask and the substrate with the liquid coating, there is no need to adapt the mask to the contours of the substrate. Examples of such substrates are interior or exterior automobile parts, such as mirror housings or center consoles. However, the method of the invention can also be used for other substrates, such as household goods, sporting equipment, and electronic goods, such as electric shavers, mobile phones, and computer accessories or computer housings.

The mask used in the method has parts which are at least partly opaque and parts which are transparent with respect to the curing radiation. The at least partly opaque parts have a lower transmission of the curing radiation than the transparent parts. It is also possible that the at least partly opaque parts are fully opaque, i.e. that the curing radiation is not transmitted through these parts at all. The distribution of at least partly opaque and transparent parts determines the pattern which will become visible on the coated substrate. The mask suitably has the form of a sheet. In one embodiment, the mask is a plastic sheet made from a plastic material which is at least partly transparent to ultraviolet radiation. Alternatively, the mask may be made of other materials, for example glass or quartz.

In one embodiment, the at least partly opaque parts of the mask may be generated by printing on a plastic sheet using a printing material which is at least partly opaque with respect to the radiation used for curing. Printing can suitably be carried out using an inkjet printer or a laser printer. As printers are usually controlled by computers, such an embodiment has the advantage that individualized patterns can be applied to industrial goods at relatively low cost and in an automated way.

As mentioned above, the distribution of at least partly opaque and transparent parts determines the pattern which will become visible on the coated substrate. With the printing technique it is possible to generate different kinds of patterns on the coated substrate, for example letters, symbols, signs, and emblems. The method can also be used to apply hallmarks to coated products to facilitate identification of products. In still another embodiment the method can be used to generate a specific surface structure of a coated substrate, for example to imitate the surface of wood, or to generate a riblet structure for drag reduction on airplanes or sporting equipment.

There is no contact between the mask and the liquid coating during the irradiation step. The mask can suitably be provided in a frame or holder. In order to fix the mask during irradiation, the frame or holder may be attached to the substrate or to the radiation source. The distance between the mask and the coated substrate may vary considerably. Generally, the resolution of the pattern which can be generated on the coated substrates decreases with increasing distance between the mask and the coated substrate. Generally, the distance between the coated substrate and the mask is in the range of about 100 cm to about 0.01 cm.

When the substrate has three-dimensional surface contours, the distance between substrate and mask is not fixed for the entire substrate surface, but varies with the position on the substrate surface, if an essentially flat sheet is used as mask.

The variable distance between the essentially flat mask and the surface of a substrate having three-dimensional surface contours may cause a geometric distortion of the pattern applied to the coated substrate. In one embodiment, the application of at least partly opaque areas to the mask is carried out to compensate that geometric distortion.

As mentioned above, the applied liquid coating is irradiated through the mask without contact between the mask and the coating to cure the irradiated areas of the coating. Examples of suitable forms of radiation include electron beam radiation, ultraviolet (UV) radiation, visible light, and infrared radiation. UV radiation, and in particular the less dangerous UV-A radiation, is preferred. The duration of irradiation depends, among others, on the wavelength of the radiation, the intensity of the radiation, and, if a photolatent catalyst is employed, on the amount and type of photolatent catalyst. Suitable sources of radiation are those customary for electron beam and UV. For example, UV sources such as high-, medium-, and low-pressure mercury lamps can be used. Further examples are fluorescent tubes, deuterium halogen light sources, laser light sources, mercury-xenon lamps, UV-light emitting diodes (LEDs), and metal halide lamps. Also, for instance, gallium and other doped lamps can be used, especially for pigmented coatings. It is also possible to accelerate curing of the coating composition by means of short pulses of radiation.

It should be noted that it is also possible to apply a pattern to a substrate in a process that does not rely on a mask. In such a process, in a first step the applied liquid radiation-curable coating is irradiated locally with e.g. a laser to cure a part of the applied radiation-curable coating, while other areas remain uncured. In a further curing step the remaining, uncured areas of the coating are cured. Also in a such a process a layer thickness difference can develop in the coating at the boundary between the areas cured in the different steps.

In one embodiment of the present invention, especially when irradiating clear coats, the applied coating composition is irradiated using low-energy UV sources, i.e. by so-called daylight cure. Low-energy UV sources emit radiation of longer wavelengths than conventional UV sources. Low-energy UV sources emit hardly any UV-C radiation; they predominantly emit UV-A radiation and radiation with a wavelength at the border of UV-B and UV-A. One advantage of using a radiation source emitting radiation having a wavelength of 300 nm ≤ λ ≤ 500 nm is that it is safer to use than conventional UV sources, which emit a relatively high amount of UV-C and/or UV-B radiation. Another advantage is that daylight cure lamps are cheaper than conventional UV lamps. Commercially available daylight cure lamps are, for instance, solarium-type lamps and specific fluorescent lamps such as TL03, TL05 or TL10R lamps (ex Philips), and BLB UV lamps (ex CLE Design). As an example of a commercially available daylight cure lamp that emits short light pulses may be mentioned the mercury-free UV/VIS flash lamps of Xenon. The intensity of the radiation generally is within the range of 0.1 to 100 mW/cm²_{.}

Generally, the duration of irradiation is in the range of 0.01 second to 30 minutes. Typically, irradiation is carried out for a period of 1 second to 15 minutes.

Upon irradiation in step c), the parts of the coating which are exposed to radiation are cured and solidified. Those areas which are in the shadow of the at least partly opaque parts of the mask remain uncured and liquid. During this process, a layer thickness difference develops in the coating layer at the boundary between the areas cured in step c) and those which remain uncured in step c) and are cured later in step d). Without wishing to be bound by any theory, it is believed that the development of the layer thickness difference is cause by shrinkage of the coating during curing, or by diffusion processes of uncured coating material due to difference in chemical potential, or by a combination of both.

After step c), the mask is suitably removed before curing the remaining, uncured areas of the coating in step d). Curing of the remaining coating in step d) can be carried out using the same type of irradiation as in step c). However, if so desired, it is also possible to use other types of radiation for curing in step d), provided that the type of radiation is capable of inducing cure in the coating. If the coating composition is also curable thermally, curing in step d) can also be carried out by heating. If so desired, it is also possible to use a combination of radiation curing and heating.

The radiation-curable coating composition generally forms a top coat, for example a top coat in a multi-layer lacquer coating. In one embodiment, the radiation-curable coating composition is a clear coat composition, which may be applied on top of a colour and/or effect-imparting base coat layer. Alternatively, the radiation-curable coating composition may be a pigmented coating composition.

### Example

### Replication of a Sierpinsky gasket into a UV-curing clear coat

### Production of photo-mask

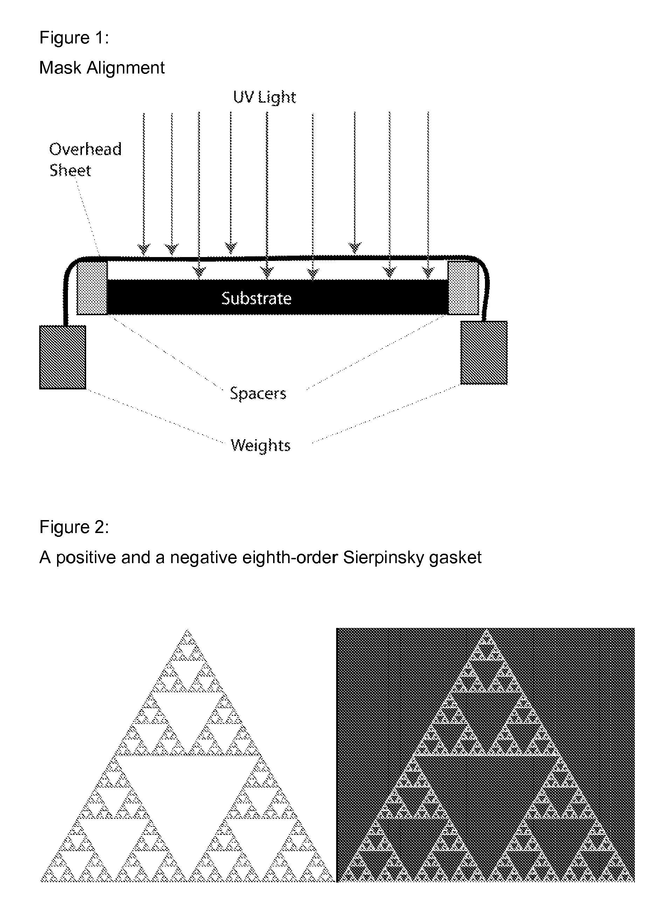

An eighth-order Sierpinsky gasket as shown in Figure 2 was printed on a 3M CG3300 overhead sheet using a Hewlett Packard 4600 Color LaserJet printer. The printer was set to black and white printing at 600 dpi. The main equilateral triangle's sides had a length of 10 cm. Both a positive and a negative print were made.

### Preparation of UV-curable clear coat

Sikkens Autoclear^{®} UV was used as a UV-curable clear coat composition.

A 25 × 10 cm² coil coat panel was coated with Sikkens Autowave^{®} aqueous base coat (black) using the standard procedure described in the technical data sheet. The Sikkens Autoclear^{®} was coated on top of that, again using the standard application procedure described in the technical data sheet.

### Selective UV curing process

An UV400 flood light from UV light technologies Ltd. was used as a UV irradiation source. The UV lamp was switched on 20 minutes before the UV curing started. The coated panel with the UV-unexposed clear coat was placed on a sample holder. The photo-mask was fixed above the panel at a distance of 0.5 cm using spacers. The overhead sheet was straightened out using weights. The alignment of the mask and the substrate is outlined in Figure 1. The photo-mask was covered with an aluminium plate in order to protect it from UV light. The sample holder containing the panel and the photo-mask was positioned 40 cm underneath the UV lamp. The aluminium plate was removed, and the clear coat was irradiated through the mask for 6 minutes. After the selective curing finished, the photo-mask was removed, and the clear coat was flood-cured.

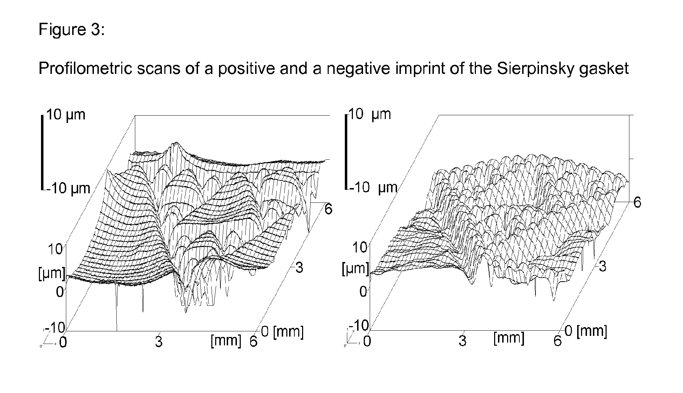

A good replication of the Sierpinsky gasket was visible in the clear coat after curing. Figure 3 shows profilometric scans which demonstrate that the impression of the negative mask protrudes out of the film, while the impression of the positive mask is indented in the film.

## Claims

1. A method of applying a pattern to a coated substrate, said method comprising:
a) applying a liquid, radiation-curable coating composition to a substrate;
b) providing a mask having parts which are at least partly opaque and parts which are transparent with respect to the curing radiation;
c) irradiating said liquid coating through the mask, without contact between said mask and said coating, to cure the irradiated areas; and
d) curing the remaining, uncured areas of the coating;
wherein a layer thickness difference develops in said coating at the boundary between the areas cured in step c) and those cured in step d).

2. The method according to claim 1, wherein the substrate has three-dimensional surface contours.

3. The method according to claim 1, wherein the substrate is an exterior or interior automobile part.

4. The method according to claim 1 or 2, wherein the radiation-curable coating composition comprises binders comprising ethylenically unsaturated groups capable of radical polymerization.

5. The method according to claim 1 or 2, wherein the radiation-curable coating composition comprises a photolatent base and a base-catalyzed polymerizable or curable material.

6. The method according to claim 5, wherein the base-catalyzed curable material comprises at least one polyisocyanate and at least one compound comprising at least one thiol group.

7. The method according to claim 1 or 2, wherein the radiation-curable coating composition comprises a hydroxy-functional binder, a polyisocyanate, and a photolatent catalyst for the addition reaction of hydroxy groups to isocyanate groups.

8. The method according to any one of the preceding claims, wherein the irradiation in step c) is carried out using ultraviolet radiation.

9. The method according to any one of the preceding claims, wherein the curing in step d) is carried out using the same type of irradiation as in step c).

10. The method according to any one of the preceding claims, wherein the radiation-curable coating composition forms a top coat in a multi-layer lacquer coating.

11. The method according to any one of the preceding claims, wherein the radiation-curable coating composition is a clear coat composition.

12. The method according to any one of the preceding claims, wherein the radiation-curable coating composition is a pigmented coating composition.

13. The method according to any one of the preceding claims, wherein the mask is a plastic sheet.

14. The method according to claim 13, wherein the at least partly opaque parts are printed on the plastic sheet using a laser printer or an inkjet printer.
